Europäisches Patentamt

European Patent Office

Office européen des brevets

(11) Numéro de publication: **0 495 041 A1**

# DEMANDE DE BREVET EUROPEEN
## publiée en application de l'article 158, paragraphe 3 de la CBE

(21) Numéro de dépôt: **91913704.2**

(22) Date de dépôt: **30.07.91**

(86) Numéro de dépôt internationale :
**PCT/ES91/00050**

(87) Numéro de publication internationale :
**WO 92/02471 (20.02.92 92/05)**

(51) Int. Cl.$^5$: **C04B 35/49**, H01G 4/12, H01L 41/18

(30) Priorité: **30.07.90 ES 9002047**

(43) Date de publication de la demande:
**22.07.92 Bulletin 92/30**

(84) Etats contractants désignés:
**DE FR NL**

(71) Demandeur: **ERCROS S.A.**
**Avda. de la Diagonal 593-595**
**ES-08014 Barcelona(ES)**

(72) Inventeur: **ORGAZ ORGAZ, Felipe**
**Corregidor Diego de Valderábanos, 17**
**E-28030 Madrid(ES)**
Inventeur: **CAMPO VELASCO, Marina**
**Avenida de Burgos, 28**
**E-28036 Madrid(ES)**
Inventeur: **DURAN BOITIA, Pedro**
**L pez de Hoyos, 28**
**E-28002 Madrid(ES)**

(74) Mandataire: **Garcia Cabrerizo, Francisco**
**OFICINA GARCIA CABRERIZO S.L. Vitruvio 23**
**E-28006 Madrid(ES)**

(54) **PROCEDE DE PREPARATION DE MATERIAUX CERAMIOUES PIEZOELECTRIOUES EN PZTN.**

(57) Procédé pour la préparation d'une matière céramique piézo-électriques de PZTN par l'intermediarie de l'addition à la chamotte calcinée d'oxydes de 5% en poids du co-précipité d'hydroxydes de la même composition que la chamotte et ayant la même relation stoechiométrique parmi les métaux constituants que celle existant dans ladite chamotte. L'oxydes constituants de la chamotte sont PbO, $ZrO_2$, $TiO_2$ et $Nb_2 O_5$. Le matière PZTN répond à la formule de base:

$$Pb(Ti_{0,47} Zr_{0,53}) O_3 + 0.015 Nb$$

Le matiére fritté à une temperature de 1000$\underline{o}$C-1125$\underline{o}$C et polarise présente de bonnes propriétés diélectriques et piézo-électriques, haut température de Curie et il est utile pour la fabrication d'igniteurs, résonateurs et transducteurs soniques et ultrasoniques.

EP 0 495 041 A1

FIGURE 3

La présente invention se rapporte en général à un procédé de préparation d'une matière céramique ferroélectrique de Zirconotitanate de plomb (PZT), en particulier, l'invention se rapporte à la préparation d'un "PZT" dopé de niobium (PZTN), au moyen de l'addition de phases soudantes préparées par co-précipitation, à un produit précalciné de la même composition, préparé par la méthode des oxydes. L'invention se rapporte également à la matière obtenue par ce procédé, ainsi qu'à l'utilisation de cette matière pour la fabrication de matières ou articles dotés de bonnes propriétés diélectriques et piézo-électriques.

L'usage des céramiques avancées dans des applications électroniques et électriques a subi un développement important ces dernières décades. Leur utilisation va des condensateurs, substrats et capsulages pour circuits électriques, varistors, résonateurs, allumeurs et filtres de fréquences, jusqu'aux cellules de combustible ou aux supraconducteurs.

Les céramiques piézo-électriques forment un groupe dans lequel sont classées les céramiques électroniques et elles constituent le groupe le plus important de celles qui sont connues comme céramiques avancées, également appelées céramiques de hautes prestations, céramiques fines ou céramiques techniques. Les matières céramiques piézo-électriques ou matières piézocéramiques sont des composés de nature céramique capables de développer une polarisation électrique spontanée lorsqu'elles sont soumises à un effort mécanique, et inversement lorsqu'elles sont soumises à un champ électrique, elles produisent des déformations mécaniques.

Les développements les plus récents des applications piézocéramiques sont les éléments multicouches de forte puissance et ceux appelés moteurs ultrasoniques.

Les matières utilisées pour préparer les céramiques piézo-électriques sont principalement le titanate de baryum, le titanozirconate de plomb (PZT), le niobate de plomb et, à un moindre degré commercial, le titanate de bismuth, le niobate de sodium et de potassium et le titanate de plomb.

Le titanate de baryum a été la première matière céramique piézo-électrique à être utilisée telle quelle, bien qu'actuellement, on l'utilise plus couramment dans des condensateurs que comme piézo-électrique.

Le zirconotitanate de plomb (PZT) est la piézo-céramique la plus amplement utilisée ces dernières années. PZT est une solution solide composée de titanate de plomb ($PbTiO_3$) et de zirconate de plomb ($PbZrO_3$) et sa formule générale est $Pb(Ti_xZr_y)O_3$ où "x" varie entre 0,10 et 0,60 et "y" varie entre 0,90 et 0,40, la somme de "x" et "y" étant égale à 1. Il est particulièrement utile dans des résonateurs de faible puissance, des capteurs de pression, des accéléromètres, des récepteurs, des médiateurs de flux, des transducteurs soniques et ultrasoniques, l'instrumentation médicale, des générateurs de haute tension, des allumeurs et des applications ultrasoniques de forte puissance (soudure, nettoyage, atomisation, etc.).

Les PZT présentent des avantages par rapport au titanate de baryum par le fait qu'ils ont un plus grand coefficient d'accouplement, une température plus élevée de Curie, une gamme plus ample de constantes diélectriques et qu'ils sont très faciles à fritter et à polariser. Enfin, ils forment des solutions solides avec un grand nombre de composés chimiques, ce qui permet d'obtenir des propriétés très variées.

Le niobate de plomb a une température de Curie très élevée qui justifie son utilisation, malgré son prix élevé, dans des applications en tant qu'accéléromètres pour des centrales nucléaires.

Les matières piézocéramiques en PZT peuvent être préparées de deux façons :
- Via oxydes
- Via co-précipitation chimique (sol-gel).

La première de ces façons est la plus amplement utilisée dans la majorité des procédés industriels de production de ces matières céramiques.

Dans le brevet JP 79 038 319 à Matsushita Electric Industrial Co. Ltd., on prépare PZT dopé de strontium à partir des oxydes des métaux, en frittant à une température entre 950 et 1150°C, pour obtenir une matière d'une densité finale de 7,55 g/cm³.

De même, T. Ogawa, dans le brevet DE 2932870 décrit le frittage de PZT dopé d'étain et d'antimoine, à 1100-1350°C, avec utilisation d'une atmosphère d'oxygène qui permet d'obtenir des matières ayant des densités proches de la densité théorique, en évitant la volatilisation de PbO.

L'utilisation du niobium comme agent dopant de PZT préparé à partir des oxydes, conjointement avec l'addition d'oxyde de nickel, est décrite dans le brevet JP 62 119 802 de Matsushita Electric Industrial Co. Ltd., où le frittage est effectué à 1150°C. La matière obtenue présente des propriétés utiles pour son application dans des condensateurs multicouches.

L'addition d'un alcoolate d'aluminium à un mélange calciné d'oxydes de plomb, de zirconium et de titane, contenant de petites quantités d'antimoine et de strontium, est mentionnée dans le brevet JP 63 270 320 de Hitachi Metals Ltd., où le frittage est effectué à 1250°C pendant 2 heures, ce qui permet d'obtenir PZT avec une haute résistance mécanique et $d_{31} = 310 \times 10^{-12}$.

La seconde façon (co-précipitation) comprend la formation d'un gel, généralement à partir de réactifs organométalliques des métaux qui forment le PZT, de façon qu'après son traitement, on obtienne des matières céramiques avec une microstructure très homogène et contrôlée, ayant des propriétés piézo-électriques améliorées. Ce dernier procédé, étant donné son prix élevé de production, est utilisé uniquement dans le cas de dispositifs de forte valeur ajoutée.

Shirasaki, Nakamishi et Kakegawa, dans le brevet JP 61 106 456, décrivent la préparation de PZT à partir de nitrates de plomb et de zirconium et de tétrachlorure de titane, par co-précipitation de l'hydroxyde multiple, en frittant dans une atmosphère d'oxygène et d'oxyde de plomb à 1200°C pour ainsi obtenir des matières ayant des densités proches de la théorie (99%).

Dans le brevet JP 62 021 760 de TDK Corp., est décrite la préparation de PZT dopé de niobium et de cobalt par co-précipitation des hydroxydes, réalisée en deux étapes, à partir des nitrates et chlorures de plomb, titane et zirconium. Ce procédé permet d'obtenir des matières ayant des densités de 99,9% après un frittage à 1000-1500°C. La préparation de poudres de PZT par coprécipitation permet, dans de nombreux cas, de réduire la température de frittage, évitant de produire des pertes importantes par volatilisation de PbO, ce qui rend généralement nécessaire l'utilisation d'atmosphères riches en vapeur de PbO. Ainsi, dans le brevet JP 62 162 670, de Fukaya et autres, est décrite la préparation de poudres pressées de PZT préparées à partir d'alcoolates, que l'on fritte à 1000°C sans nécessiter l'utilisation d'une atmosphère de PbO.

Le procédé de mélange des oxydes présente quelques limites, telles que, entre autres, la difficulté d'obtenir des produits avec une haute reproductivité et des densités proches de la théorie (96-98%). La production par co-précipitation chimique est limitée par le prix élevé des matières premières, qui seul justifie une utilisation dans des applications très spécifiques.

Additionnellement, l'un des problèmes les plus importants qui se présentent pendant le procédé d'obtention de PZT est le contrôle de la volatilité de PbO parce que les pertes de PbO modifient la stéréochimie du produit final, ce qui influence de manière décisive sur les propriétés diélectriques et piézo-électriques du PZT fritté.

C'est pourquoi la présente invention a pour objet un procédé de préparation d'une matière de PZT qui supprime les inconvénients précédemment signalés. Le procédé de l'invention comprend, à la base, l'addition de petites quantités de gels préparés par co-précipitation à un produit précalciné de la même composition préparé par la méthode des oxydes. Cela permet un meilleur traitement des matières par le fait que les gels agissent comme des phases soudantes des grains du PZT calciné, agissant ainsi comme minéralisateurs du procédé de frittage, permettant de réaliser ce procédé à des températures inférieures à celles habituelles (à peu près inférieures à 100-150°C). De cette façon, on peut maintenir un contrôle très efficace de la volatilité de PbO,en maintenant la stéréochimie de PZT et le frittage peut être réalisé à l'air libre.

D'autres objets de l'invention sont constitués par une matière de PZT dopé de niobium (PZTN), que l'on obtient selon le procédé de l'invention, qui permet d'obtenir, après frittage et polarisation, une matière de PZTN dotée de bonnes propriétés électriques et piézo-électriques et ayant une haute température de Curie.

La présente invention a pour autre objet un procédé de fabrication d'articles conformés, frittés et polarisés à base de PZTN, que l'on obtient selon le procédé de l'invention. Ces articles ont des constantes piézo-électriques élevées ainsi qu'une haute température de Curie ce qui les rend adéquats à des applications, entre autres, dans des allumeurs, des résonateurs et des transducteurs soniques et ultrasoniques.

Ces objets et d'autres seront mieux décrits dans la description qui suit.

La figure 1 montre le diffractogramme des rayons X de la chamotte calcinée d'oxydes, où on peut noter qu'il y a un mélange de phases de symétrie tétraédrique et rhomboédrique.

La figure 2 montre le diffractogramme des rayons X du co-précipité des hydroxydes où on peut noter qu'il y a une structure amorphe.

La figure 3 est une microphotographie d'une matière typique de PZTN selon l'invention, constituée d'un mélange de la chamotte calcinée d'oxydes et des phases soudantes d'hydroxydes.

La figure 4 montre la variation de la densité de divers échantillons frittés en matière de PZTN selon l'invention (préparés par additions variables des phases soudantes) en fonction de la température.

La figure 5 montre le diffractogramme des rayons X d'une matière de PZTN frittée selon l'invention, où l'on peut noter qu'il y a une structure cristalline préférentiellement rhomboédrique.

L'invention propose une matière de PZT dopé de niobium (PZTN) représentée par la composition de base $Pb(Zr_{0,53}Ti_{0,47})O_3$ qui contient également 1,5 atomes% de Nb et où on a ajouté une quantité de gel de la même composition qui varie entre 1% et 5% en poids. Le gel a une taille du grain qui est bien plus petite aussi bien du fait de son procédé de préparation que par le fait qu'il n'est pas calciné, donc sa réactivité est très élevée et cela permet de réaliser l'étape de frittage à des températures inférieures à celles requises dans la préparation d'un PZT préparé à partir d'oxydes exclusivement.

La matière de PZTN selon l'invention, une fois frittée et polarisée, présente de bonnes propriétés diélectriques et piézo-électriques,ce qui la rend adéquate à la fabrication d'articles nécessitant ces caractéristiques.

L'invention propose, d'une part, une matière de PZT dopé de niobium (ci-après PZTN) qui, une fois conformée, frittée et polarisée, est adéquate à son application dans des mécanismes et appareils qui nécessitent une conversion électromécanique d'énergie, comme des allumeurs, des transducteurs, des résonateurs, etc.

De même, la présente invention propose un procédé de préparation de cette matière de PZTN,sous la forme de poudres et apte en tant que substrat de frittage,par l'incorporation de phases soudantes à un mélange calciné d'oxydes de la même composition et de la même stéréochimie que les phases soudantes. De plus, on propose également un cycle thermique adéquat à utiliser avec cette matière de PZTN dans l'étape de frittage afin d'obtenir, après polarisation, un article final doté des catactéristiques nécessaires pour des applications piézo-électriques. Enfin, et comme cela sera évident, l'invention propose des articles conformés, frittés et polarisés constitués de cette matière de PZTN.

Afin d'éviter les confusions, dans ce qui suit, on utilisera le terme "matière de PZTN" pour indiquer la matière obtenue par addition à une chamotte calcinée d'oxydes, des phases soudantes de la même composition.

Le procédé général de préparation des matières piézo-électriques de PZTN de la présente invention comporte les étapes suivantes :

1) Préparation d'une chamotte calcinée à partir des oxydes des métaux la constituant.

2) Addition et mélange des phases soudantes, préparées par co-précipitation, à la chamotte des oxydes.

3) Conformation du mélange par pression uniaxiale ou isostatique.

4) Frittage des pièces au moyen du cycle thermique adéquat.

5) Métallisation et polarisation des pièces en conditions de temps, température et champ électrique qui permettent d'obtenir la polarisation à la saturation.

La préparation de la chamotte calcinée d'oxydes comprend les étapes suivantes :

a) Mélange-broyage des oxydes constituant la chamotte, dont la relation et la proportion en poids sont comme suit :

|  | % en poids |
|---|---|
| PbO | 68,3 |
| $ZrO_2$ | 20,0 |
| $TiO_2$ | 11,1 |
| $Nb_2O_5$ | 0,6 |

en présence d'un solvant, dans un broyeur, pendant une période de temps comprise entre 2 et 4 heures, de façon à obtenir une suspension homogène avec une bonne dispersion des constituants. Comme solvant, on peut utiliser des alcools, des cétones et même de l'eau. En particulier, on a observé que les alcools, plus concrètement, le méthanol, l'éthanol ou l'isopropanol, étaient des solvants adéquats. Le broyeur peut être de tout type bien que soient particulièrement adéquats un broyeur par attrition ou un broyeur à billes. Les proportions des oxydes composants ont une grande importance parce qu'au moyen de ces proportions, on peut obtenir une matière de PZTN qui a une formule de base représentée par $Pb(Ti_{0,47}Zr_{0,53})O_2$ et contenant 1,5 atomes% de Nb.

b) Séchage sans séparation de la suspension précédemment obtenue, par centrifugation ou par séchage dans une étuve avec agitation.

c) Calcination du mélange des oxydes à une température comprise entre 800°C et 850°C pendant une période de temps d'environ 4 heures, en effectuant la calcination en atmosphère oxydante (à l'air).

d) Broyage de la chamotte calcinée dans un broyeur, en utilisant un solvant et un agent défloculant pendant une période de temps comprise entre 8 et 24 heures.

e) Séchage de la suspension résultante du produit broyé dans une étuve à une température comprise entre 60°C et 70°C, pendant une période de temps d'environ 10 heures.

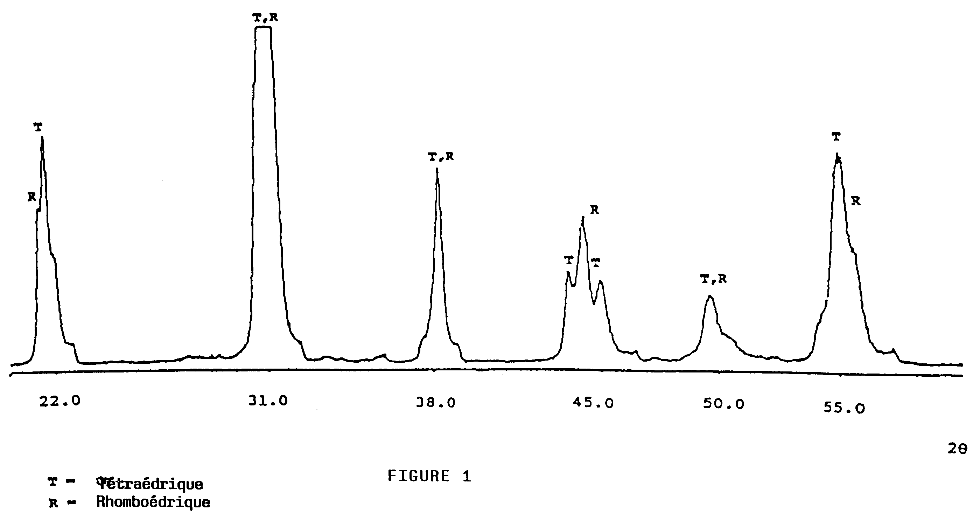

La chamotte calcinée des oxydes ainsi préparée présente une structure préférentiellement tétragonale correspondant à une composition à la limite morphotrope des phases, comme cela est réfléchi par le diffractogramme des rayons X représenté à la figure 1. Ces poudres ont un diamètre moyen du grain de l'ordre de 1 à 1,5 $\mu$m.

Les phases soudantes sont obtenues par co-précipitation des hydroxydes des métaux qui forment la chamotte des oxydes et avec la même relation stoechiométrique parmi les métaux que la relation stoechiométrique parmi les métaux qui existent dans la chamotte des oxydes. Cette co-précipitation des hydroxydes est préparée par addition d'une solution de tétrabutoxydes de titane et de zirconium dans un solvant alcoolisé et dans un milieu acide sur une suspension de PbO et de $Nb_2O_5$ dans de l'eau et de l'alcool. La précipitation est terminée par addition d'ammoniaque sur la suspension antérieure. Les alcools adéquats pour la réalisation de cette étape sont choisis parmi le méthanol, l'éthanol et l'isopropanol.

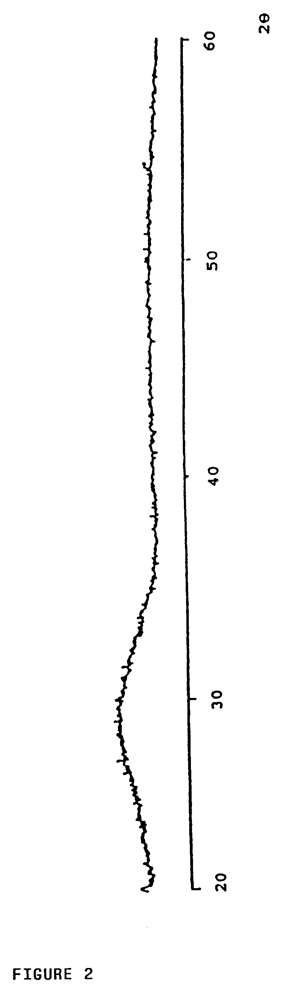

Quand l'hydroxyde multiple de Pb, Ti, Zr et Nb est formé, on filtre et on lave avec un mélange abondant d'eau/alcool, et la poudre récupérée est séchée dans une étuve à 60-80°C pendant plusieurs heures, et on tamise. Ce co-précipité, ainsi préparé, est amorphe aux rayons X, comme on peut le voir à la figure 2, présentant une grandeur du grain de la taille inférieure au micron.

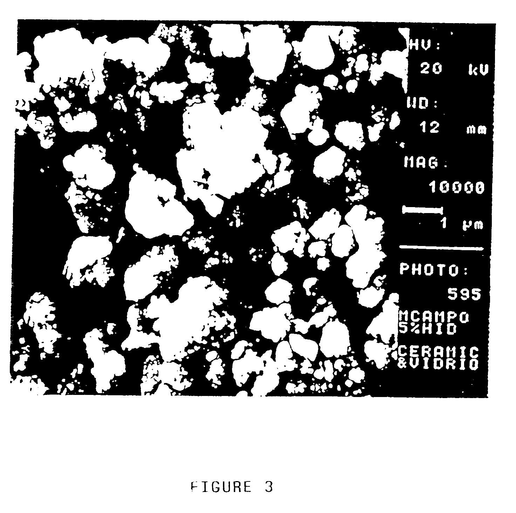

L'étape suivante (2) comprend l'addition du gel du co-précipité des hydroxydes ou phases soudantes sur la chamotte calcinée des oxydes. Les quantités des phases soudantes à ajouter peuvent varier entre 1% en poids et 5% en poids, en se référant au total de la chamotte des oxydes. Cette étape est réalisée en formant une suspension de la chamotte des oxydes et des phases soudantes aux quantités adéquates, dans le solvant utilisé pour la préparation des phases soudantes et, facultativement, on peut ajouter un agent agglomérant ainsi qu'un plastifiant parmi ceux habituellement utilisés dans ces procédés. La suspension résultante est soumise à agitation à vitesse rapide pendant quelques minutes et ensuite elle est séchée, par atomisation ou bien par centrifugation,avec ensuite tamisage et mise en boulettes postérieure dans ce dernier cas. La matière ainsi obtenue, en forme de granules ou de poudre, constitue le PZTN de l'invention et sa formule de base est constituée de $Pb(Ti_{0,47}Zr_{0,53})O_3$ + 0,015 Nb. Sur la figure 3, est montrée une microphotographie de l'un des mélanges chamotte d'oxydes-phases soudantes (co-précipité d'hydroxydes), plus concrètement un mélange où la quantité des phases soudantes est de 5% en poids.

L'étape (3) qui suit consiste à conformer le mélange chamotte calcinée-phases soudantes en la pièce souhaitée par compression uniaxiale ou isostatique à des pressions comprises entre 100 MPa et 200 MPa.

Ensuite, les pièces pressées sont frittées à une température comprise entre 1000°C et 1125°C, à l'air libre, sans utilisation d'atmosphère protectrice de PbO. Le cycle thermique adéquat pour le frittage de PZTN selon l'invention comprend une première phase à une vitesse de chauffage très lente (environ 60-80°C/h) pour la volatilisation des additifs organiques et pour éviter qu'il se forme des crevasses du fait d'une brusque conversion des hydroxydes en oxydes. Dans la seconde phase, une fois qu'est atteinte la température de frittage (1000°C-1125°C), celle-ci est maintenue pendant une période de 1 à 8 heures pour permettre de terminer la densification de la matière frittée. Enfin, la pièce est refroidie à température ambiante à une vitesse de 300-400°C/h.

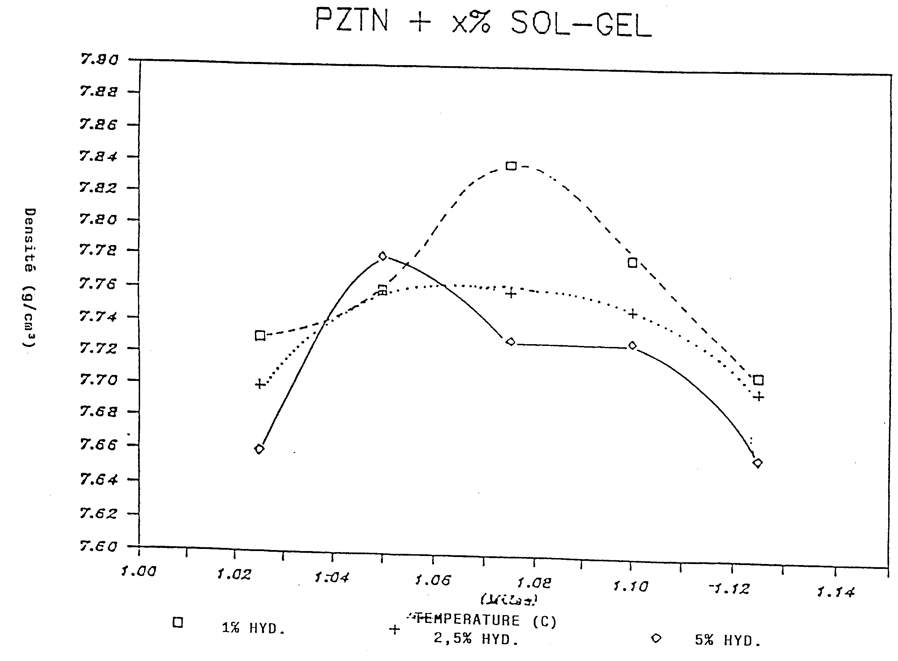

Les échantillons frittés présentent une densité qui varie entre 96% et 98% de la théorie, c'est-à-dire entre 7,70 et 7,85 $g/cm^3$, selon les conditions de frittage et la composition de chaque matière. Sur la figure 4 est représentée la densité en fonction de la température des échantillons avec des additions diverses de phases soudantes, plus concrètement avec addition de phases soudantes à raison de 1% en poids (□), 2,5% en poids ( + ) et 5% en poids (◊).

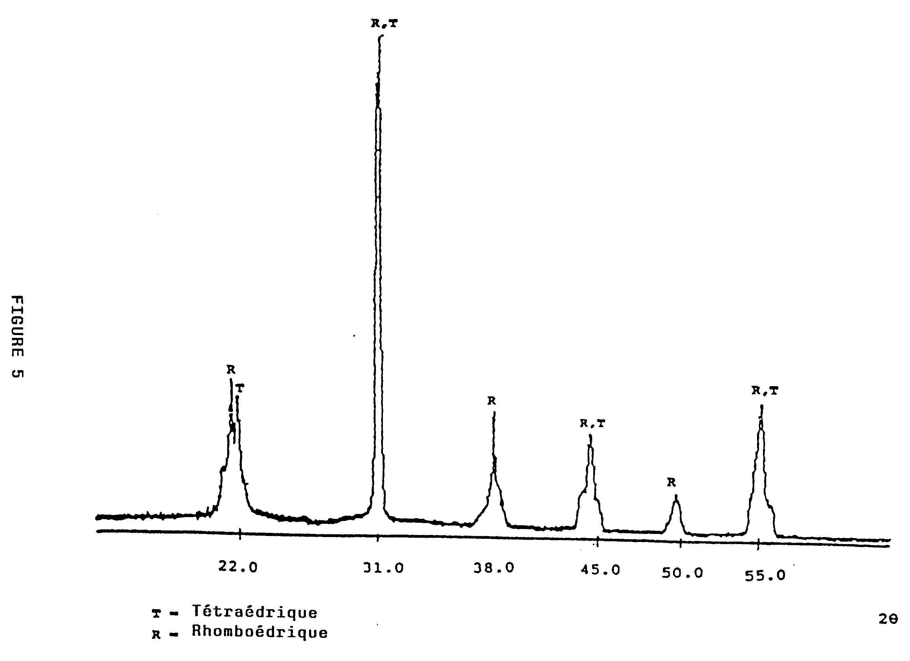

La microstructure de ces matières présente deux types de grains différenciés : ceux qui sont petits (1-2 $\mu$m) entourés des autres plus grands (3-5 $\mu$m). Les petits grains proviennent des phases soudantes, qui agissent comme des points de cristallisation pour les grains plus grands, provenant des oxydes. De plus, ces matières présentent une faible porosité, étant du type fermé. Ces matières présentent de même une structure cristalline, préférentiellement rhomboédrique,telle que le montre la figure 5.

On a pu vérifier que l'addition des phases soudantes très réactives à une chamotte calcinée des oxydes de la même composition que ces phases soudantes, favorisait la réaction de densification (en obtenant des densités de 96-98% par rapport à la théorie) avec des températures et des temps inférieurs à ceux des procédés habituels. En augmentant la réactivité du mélange chamotte calcinéephases soudantes, on diminue la température de frittage nécessaire pour obtenir les meilleures densités, on contrôle la croissance du grain et on réduit les pertes de PbO par volatilisation, ce qui évite l'apparition de défauts de structure (porosité, phases liquides, etc..) et de composition (perte de stéréochimie). Cependant, on obtient des matières de bonnes propriétés physiques, avec une stéréochimie contrôlée et avec des propriétés piézo-électriques,une fois polarisées, également bonnes (et dans certains cas meilleures) que celles des matières de PZT obtenues par des méthodes traditionnelles.

Ces matières sont capables de résister à des champs électriques très élevés (> 50 KV/cm) pendant la polarisation sans qu'il y ait rupture électrique, ce qui suppose une amélioration des paramètres piézo-électriques.

Après le frittage, a lieu l'étape de métallisation et de polarisation et pour cela, les matières de PZTN précédemment obtenues sont plaquées électrolytiquement d'argent et durcies à une température comprise entre 200°C et 500°C pendant une période de temps comprise entre 1 et 2 heures. Les échantillons ou pièces plaqués et durcis sont soumis au procédé de polarisation qui est réalisé en immergeant l'échantillon dans un bain d'une huile minérale ou de silicone, à une température comprise entre 100°C et 125°C et en appliquant un champ électrique de 30 à 50 KV/cm pendant une période de temps comprise entre 20 et 30 minutes.

Ces matières, une fois polarisées, ont une température de Curie qui varie entre 310 et 370°C, selon la quantité de la phase soudante ajoutée et les procédés de frittage et de polarisation. Les constantes d'accouplement plan ($K_p$) oscillent entre 0,50 et 0,62 ; la constante diélectrique ($K_3^T \delta \epsilon'$) est aux environs de 800-1200 et les constantes piézo-électriques de force et de tension ($d_{33}$ et $g_{33}$) sont de 275-340 x $10^{-12}$ C/N et de 20-30 x $10^{-3}$Vm/N, respectivement.

Les exemples qui suivent décrivent plus particulièrement la présente invention, servant à illustrer des formes particulières de réalisation de celle-ci sans pouvoir être considérés comme restrictifs.

EXEMPLE 1

On prépare une chamotte de 500 g à partir d'oxydes aux quantités suivantes :

| | |
|---|---|
| PbO | 341,5 g |
| ZrO$_2$ | 103,36 g |
| TiO$_2$ | 55,75 g |
| Nb$_2$O$_5$ | 3,06 g |

Les oxydes sont mélangés dans un broyeur à billes avec 500 ml de méthanol, en utilisant un agent défloculant, pendant 4 heures. La suspension est séchée en centrifugeuse et ensuite on calcine à 800°C pendant 4 heures. Le mélange, une fois calciné, est moulu dans un broyeur à billes pendant 24 heures en utilisant du méthanol comme solvant et un agent défloculant. La suspension est séchée à 60-70°C pendant 8-10 heures en étuve.

On prépare également 100 g de gel d'hydroxydes en ajoutant, à une suspension de PbO (68,45 g) et de Nb$_2$O$_5$ (0,612 g) dans l'isopropanol/eau (1:1), une solution de tétrabutoxyde de titane (49 ml) et de tétrabutoxyde de zirconium (71,56 ml) dans l'isopropanol (500 ml). La précipitation du gel se produit après addition, à la suspension finale, d'un mélange d'ammoniaque/ eau (1:1). Le gel est filtré et lavé avec un mélange d'isopropanol/eau jusqu'à neutralisation complète. Une fois que le gel est lavé, on termine le séchage dans une étuve à 60-70°C pendant 8-10 heures. Le gel, une fois sec, est tamisé à moins de 60 μm.

Ensuite, on prépare les mélanges chamotte-co-précipité aux quantités suivantes (en grammes) :

| COMPOSITION | CHAMOTTE | CO-PRECIPITES |
|---|---|---|
| A (1%) | 100 | 1,0 |
| B (2,5%) | 100 | 2,5 |
| C (5%) | 100 | 5,0 |

Le mélange est réalisé en présence d'isopropanol, en agitant à vitesse rapide pendant quelques minutes, en ajoutant à la suspension un agent agglomérant (XUS de Dow Chemical) et un plastifiant (polyéthylène glycol). La suspension est séchée en centrifugeuse et est tamisée à moins de 100 μm.

A la suite de cela, on conforme la matière de PZTN par presse isostatique à 200 MPa. Les pièces ainsi conformées sont frittées en atmosphère oxydante à une température comprise entre 1000 et 1125°C pendant un temps de 1 à 8 heures. La densité des matières frittées est déterminée par la méthode d'Archimède.

Les matières frittées sont coupées en forme de disques et cylindres dont les faces circulaires planoparallèles sont plaquées d'argent, en durcissant ensuite les pièces à 500°C pendant une heure. Ensuite, les pièces sont polarisées à 100-120°C pendant 20-30 minutes par application d'un champ électrique de 30-40 KV/cm et on détermine les propriétés piézo-électriques à 24 heures de la polarisation. La température de Curie est déterminée à partir des moyennes de la constante diélectrique en fonction de la température, tandis que les paramètres piézo-électriques sont déterminés à partir des moyennes des fréquences de résonance et anti-résonance, ainsi que de la constante diélectrique.

Les propriétés de ces matières sont les suivantes:

```
COMPOSE     DENSITE     K       K            d             K       Q
                         p       t            33            3       m

            (g/cm³)                   (x10⁻¹²C/N)


A (1%)      7,84      0,58   0,50      316          1073      82

B (2,5%)    7,75      0,50   0,54      282           800      75

C (5%)      7,76      0,55   0,47      279           790      75
```

EXEMPLE 2

Une étude comparative a été réalisée avec un échantillon traité sans addition de la phase soudante mais fritté dans les mêmes conditions de temps et de température, sans utiliser d'atmosphère protectrice de PbO, telles qu'on en utilisait pour les matières contenant une addition de phases soudantes. Les résultats comparatifs de densité sont donnés au tableau qui suit :

| T° | 1025°C | 1050°C | 1075°C | 1100°C | 1125°C |
|---|---|---|---|---|---|
| SANS GEL | 7,54 | 7,67 | 7,75 | 7,73 | 7,69 |
| AVEC GEL (1%) | 7,73 | 7,76 | 7,84 | 7,78 | 7,74 |

Les propriétés piézo-électriques de la plus grande partie des échantillons qui ne contenaient pas de phases soudantes sont, dans tous les cas, plus faibles que celles des matières qui contiennent ces phases soudantes ($K_p = 0,52$, $K_t = 0,45$, $d_{33} = 262 \times 10^{-12}$, $K_3^T = 750$, $Q_m = 75$).

**Revendications**

**1.** Procédé de préparation d'une matière de PZT dopé de niobium (PZTN) qui répond à la formule de base

$$P_b(Ti_{0,47}Zr_{0,53})O_3 + 0,015 \, Nb$$

qui, après traitement, frittage et polarisation, permet d'obtenir une matière dotée de bonnes propriétés diélectriques et piézo-électriques, ledit procédé étant caractérisé en ce qu'il comprend :
a) la préparation d'une chamotte calcinée d'oxydes à partir d'un mélange de PbO, $ZrO_2$, $TiO_2$ et $Nb_2O_5$ aux proportions suivantes :

| | |
|---|---|
| PbO | 68,5% en poids |
| $ZrO_2$ | 20,0% en poids |
| $TiO_2$ | 11,1% en poids |
| $Nb_2O_5$ | 0,6% en poids ; |

b) la préparation d'un co-précipité d'hydroxydes multiples des métaux constituants (Pb, Zr, Ti, Nb) avec la même relation stoechiométrique parmi ces métaux que celle existant entre les métaux présents dans la chamotte des oxydes ;
c) l'addition de ce co-précipité d'hydroxydes à la suspension de la chamotte calcinée d'oxydes et broyée au préalable ; et
d) le séchage de la suspension résultant de l'étape c) pour obtenir la matière de PZTN en forme de poudre.

**2.** Procédé selon la revendication 1, caractérisé en ce que la quantité du co-précipité d'hydroxydes à ajouter à la chamotte calcinée d'oxydes peut varier entre 1% en poids et 5% en poids par rapport à ladite chamotte.

3. Procédé selon la revendication 1, caractérisé en ce que la suspension de la chamotte calcinée d'oxydes broyée contient facultativement un agent plastifiant.

4. Procédé selon la revendication 1, caractérisé en ce que le séchage de la suspension résultant de l'étape c) peut être effectué par atomisation ou par séchage en centrifugeuse et tamisage subséquent et mise en boulettes.

5. Matière de PZTN qui répond à la formule de base $Pb(Ti_{0,47}Zr_{0,53})O_3 = 0,015$ Nb qui, après son frittage et sa polarisation, présente de bonnes propriétés diélectriques et piézo-électriques, caractérisée en ce qu'on l'obtient par addition à une chamotte calcinée d'oxydes constituée de :

| | |
|---|---|
| PbO | 68,5% en poids |
| $ZrO_2$ | 20,0% en poids |
| $TiO_2$ | 11,1% en poids |
| $Nb_2O_5$ | 0,6% en poids |

d'un co-précipité d'hydroxydes multiples de la même composition et ayant la même relation stoechiométrique parmi les métaux constituants que celle existant entre les métaux présents dans ladite chamotte à une proportion comprise entre 1% en poids et 5% en poids en se référant à ladite chamotte.

6. Procédé pour le frittage d'articles conformés constitués d'une matière de PZTN obtenue par le procédé selon l'une quelconque des revendications 1 à 4, caractérisé en ce qu'il comprend les étapes suivantes :
   a) chauffage initial lent de l'article conformé, à une vitesse de chauffage comprise entre 60 et 80°C/h, jusqu'à atteindre une température comprise entre 1000 et 1125°C ;
   b) maintien de la température atteinte à l'étape a) pendant une période de temps comprise entre 1 et 8 heures , et
   c) refroidissement à température ambiante à une vitesse comprise entre 300 et 400°C/h.

7. Procédé de fabrication d'articles à base de PZTN, adéquats pour des applications piézo-électriques, caractérisé en ce qu'il comprend :
   a) la préparation d'une matière de PZTN selon le procédé des revendications 1 à 4 ;
   b) la mise en forme de ladite matière de PZTN en article souhaité ;
   c) le frittage de l'article conformé selon le procédé de frittage décrit à la revendication 6 ; et
   d) la polarisation dudit article conformé et fritté.

8. Procédé selon la revendication 7, caractérisé en ce que la polarisation est effectuée au moyen de :
   i) électrolyse et durcissement des surfaces de l'article ;
   ii) chauffage dudit article jusqu'à une température proche de 120°C dans un bain d'huile minérale ou de silicone ; et
   iii) application d'un champ électrique de 30 à 50 KV/cm pendant environ 20 à 30 minutes.

9. Matière de PZTN frittée et polarisée, caractérisée en ce que :
   elle est obtenue selon le procédé des revendications 1 à 4, frittée selon le procédé de la revendication 6 et polarisée selon le procédé des revendications 7 et 8 et elle présente les propriétés suivantes :
   Température de Curie comprise entre 310°C et 370°C.
   constante d'accouplement plan ($X_p$) comprise entre 0,50 et 0,62 ;
   constante d'accouplement transversal ($X_t$) comprise entre 0,47 et 0,55 ;
   constante diélectrique ($K_3^T \delta \epsilon'$) comprise entre 800 et 1200 ;
   constante piézo-électrique de force ($d_{33}$) comprise entre $275 \times 10^{-12}$ et $345 \times 10^{-12}$ C/N ; et
   constante piézo-électrique de tension ($g_{33}$) comprise entre $20 \times 10^{-3}$ et $30 \times 10^{-3}$/V.m/N.

T = Tétraédrique
R = Rhomboédrique

T,R

T

R

T,R

R

T,R

T

T,R

R

22.0          31.0          38.0          45.0          50.0          55.0

2θ

FIGURE 1

FIGURE 2

FIGURE 3

PZTN + x% SOL-GEL

FIGURE 5

# INTERNATIONAL SEARCH REPORT

International Application No  PCT/ES 91/00050

**I. CLASSIFICATION OF SUBJECT MATTER** (if several classification symbols apply, indicate all) ⁶

According to International Patent Classification (IPC) or to both National Classification and IPC

Int. Cl.⁵    C 04 B 35/49, H 01 G 4/12, H 01 L 41/18

**II. FIELDS SEARCHED**

| Minimum Documentation Searched ⁷ |
|---|

| Classification System | Classification Symbols |
|---|---|
| Int. Cl.⁵ | C 04 B, H 01 G, H 01 L |

| Documentation Searched other than Minimum Documentation<br>to the Extent that such Documents are Included in the Fields Searched ⁸ |
|---|
| |

**III. DOCUMENTS CONSIDERED TO BE RELEVANT ⁹**

| Category ⁰ | Citation of Document, ¹¹ with indication, where appropriate, of the relevant passages ¹² | Relevant to Claim No. ¹³ |
|---|---|---|
| A | World Patent Index Latest, Acc.num.<br>88-222707, week 32<br>Derwent Publications Ltd, London, GB;<br>& JP, A, 63156065 (NIPPON DENSO K.K.)<br>29 June 1988<br>--- | 1-9 |
| A | World Patent Index Latest, Acc. num.<br>88-216293, week 31<br>Derwent Publications Ltd, London, GB;<br>& JP, A,63151672 (NIPPON DENSO K.K.)<br>24 June 1988<br>--- | 1-9 |
| A | World Patent Index Latest, Acc. num.<br>90-206186, week 27<br>Derwent Publications Ltd, London, GB;<br>& JP, A, 2137727 (TOYOTA JIDOSHA K.K.)<br>28 May 1990<br>--- | 1-9 |
| A | EP, A, 0338799 (ALCAN INT. LTD)<br>25 October 1989, see claims 1-11; page 3,<br>line 44 - page 4, line 22 | 1-9 |

---

\* Special categories of cited documents: ¹⁰

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

**IV. CERTIFICATION**

| Date of the Actual Completion of the International Search | Date of Mailing of this International Search Report |
|---|---|
| 28 October 1991 (28.10.91) | 18 December 1991 (18.12.91) |

| International Searching Authority | Signature of Authorized Officer |
|---|---|
| European Patent Office | |

Form PCT/ISA/210 (second sheet) (January 1985)

This annex lists the patent family members relating to the patent documents cited in the above-mentioned international search report.
The members are as contained in the European Patent Office EDP file on 19/11/91
The European Patent Office is in no way liable for these particulars which are merely given for the purpose of information.

| Patent document cited in search report | Publication date | Patent family member(s) | | Publication date |
|---|---|---|---|---|
| EP-A- 0338799 | 25-10-89 | AU-A- | 3326889 | 26-10-89 |
| | | JP-A- | 1313356 | 18-12-89 |

EPO FORM P0479